# EUROPEAN PATENT APPLICATION

(11) **EP 1 253 648 A1**
(43) Date of publication of application: **30.10.2002**
(21) Application number: 01921894.0
(22) Date of filing: 18.04.2001
(51) Int. Cl.: H01L 29/78, H01L 29/786, H01L 21/336

(54) **P-CHANNEL FIELD-EFFECT TRANSISTOR**

(30) Priority: 19.10.2000 JP 2000318978
(71) Applicant: MATSUSHITA ELECTRIC INDUSTRIAL CO., LTD., Kadoma-shi, Osaka 571-8501 (JP)
(72) Inventor: HARA, Yoshihiro, Hirakata-shi, Osaka 573-1104 (JP); TAKAGI, Takeshi, Kyoto-shi, Kyoto 616-8182 (JP); KUBO, Minoru, Nabari-shi, Mie 518-0641 (JP)
(74) Representative: Grünecker, Kinkeldey, Stockmair & Schwanhäusser Anwaltssozietät
(86) International application number: JP0103332
(87) International publication number: WO02033759

(57) **Abstract**

In a channel layer made of SiGe containing C, the Ge composition varies linearly from 0% to 50% from one end closer to a silicon buffer layer toward the other end closer to a silicon cap layer, and C is contained at 0.5% selectively in a region where the Ge composition is 40% to 50% (i.e., a region where it exceeds 30%). By containing C at 0.5% in a region where the Ge composition is 40% to 50%, the strain amounts can be reduced by about 12% and 10%, respectively, while Ev is not substantially changed. It is possible to reduce a threshold value and to increase a driving current while ensuring a large critical thickness of the SiGe channel layer.

## Description

### TECHNICAL FIELD

The present invention relates to a p-channel type field effect transistor in which a channel is formed in an SiGeC layer.

### BACKGROUND ART

A MOS (Metal-Oxide-Semiconductor) type field effect transistor in which a p channel is formed by confining holes in an Si₁₋ₓGeₓ layer (0<x<1) (hereinafter referred to as an "SiGe layer"), which is a mixed crystal of Si and Ge, by utilizing a hetero barrier formed between the SiGe layer and an Si layer, has been reported in the prior art, aiming to increase the speed of a field effect transistor.

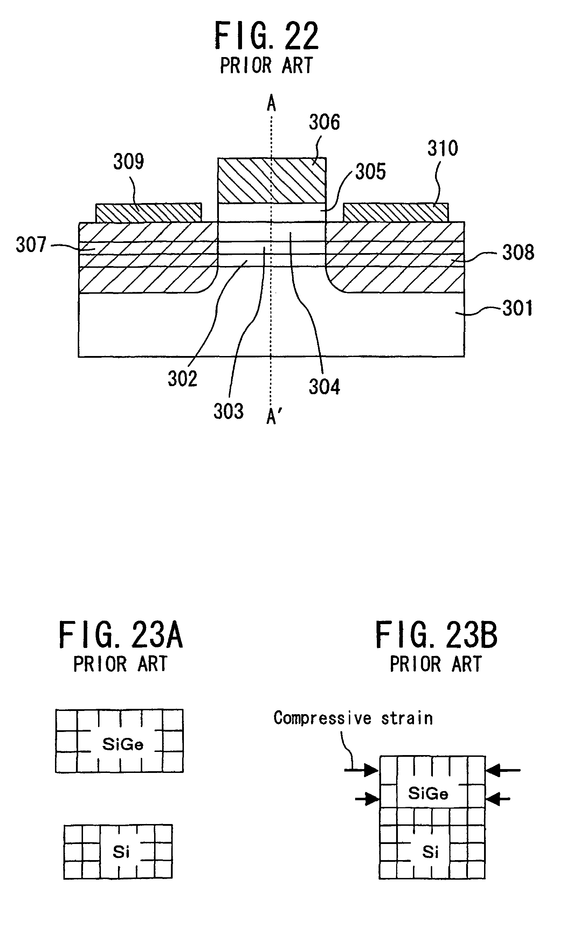

FIG. **22** is a cross-sectional view illustrating an example of such a conventional p-channel type field effect transistor (p-MOSFET). As illustrated in the figure, an Si buffer layer **302,** an SiGe channel layer **303** and an Si cap layer **304** are successively epitaxially grown on an n-type Si substrate **301** by a UHV-CVD method. The thicknesses of the Si buffer layer **302,** the SiGe channel layer **303** and the Si cap layer **304** are 10 nm, 10 nm and 5 nm, respectively, and the layers **302, 303** and **304** are not doped with an impurity. Moreover, a gate insulating film **305** made of a silicon oxide film and a gate electrode **306** made of a polysilicon film are provided on the Si cap layer **304.** Moreover, a source region **307** and a drain region **308** containing a high concentration of a p-type impurity (e.g., boron) are formed in portions of the large region across the Si buffer layer **302,** the SiGe channel layer **303** and the Si cap layer **304** that are located on opposing sides of the gate electrode **306.** A source electrode **309** is provided on the source region **307,** and a drain electrode **310** is provided on the drain region **308**. Note that the channel length and the channel width of an MOS type field effect transistor are 0.5 µm and 10 µm, for example.

FIG. **23(a)** and FIG. **23(b)** are respectively a diagram illustrating the difference in lattice constant between an SiGe single crystal and an Si single crystal, and a cross-sectional view illustrating a state where an SiGe layer is epitaxially grown on an Si layer. Since the lattice constant of an SiGe single crystal is greater than the lattice constant of an Si single crystal, as illustrated in FIG. **23(a),** the SiGe channel layer **303** is epitaxially grown on the Si buffer layer **302** while being subject to a compressive strain, as illustrated in FIG. **23(b).** In the strained SiGe channel layer **303,** the degeneracy of the energy band is lifted, whereby a light hole band and a heavy hole band are formed, and the light hole has a greater mobility than the degenerated hole in the Si single crystal. In view of this, in a conventional p-channel type field effect transistor utilizing an Si/SiGe hetero junction, the SiGe layer being subject to a compressive strain is used as a channel so as to realize a high-speed operation.

A field effect transistor using strained SiGe as a channel as described above has a problem in that a channel is formed parasitically (hereinafter referred to as a "parasitic channel") in a region of the Si cap layer **304** adjacent to the gate insulating film **305** when the gate voltage is high. The parasitic channel will now be described.

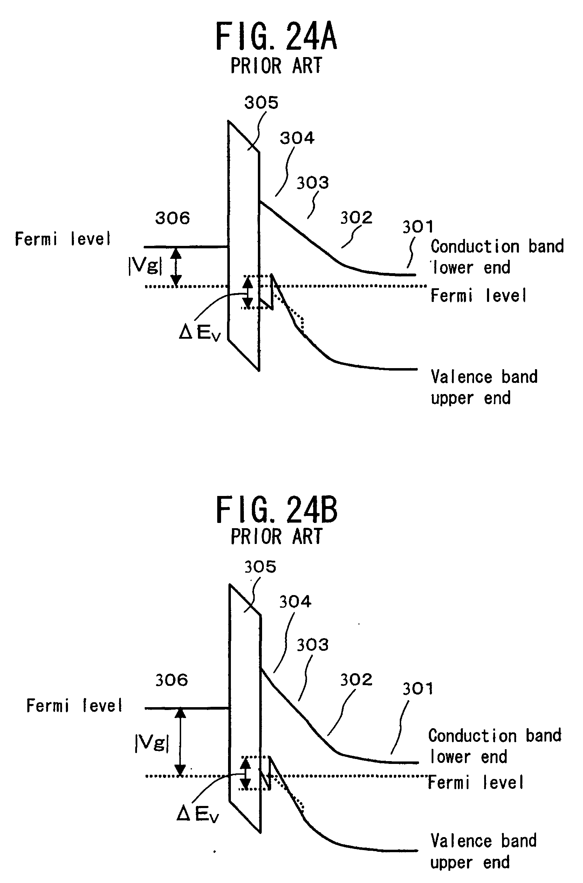

FIG. **24(a)** and FIG. **24(b)** (solid lines) are band diagrams illustrating the energy band for a small voltage application and that for a large voltage application, respectively, along a cross section vertically passing through the gate electrode **306 -** gate insulating film **305 -** Si cap layer **304 -** SiGe channel layer **303 -** Si buffer layer **302 -** Si substrate **301** of the p-channel type field effect transistor. In this example, the SiGe channel layer **303** has a Ge content (hereinafter referred to simply as a "Ge composition") that is graded substantially continuously so that it is 0% at the boundary with the Si buffer layer **302** and 30% at the boundary with the Si cap layer **304.** It can be seen that when the negative voltage Vg applied to the gate electrode **306** is small (when the absolute value thereof is small), there is no prominent parasitic channel, as illustrated in FIG. **24(a),** whereas when the negative voltage applied to the gate electrode **306** is increased (when the absolute value thereof is increased), the energy level at the upper end of the valance band in the Si cap layer **304** increases, whereby a prominent parasitic channel appears.

Moreover, in each of FIG. **24(a)** and FIG. **24(b),** a band structure in a case where the Ge composition is at a constant value of 15% is shown by a dotted line. Each solid-line band structure is a structure in a case where the Ge content in the SiGe channel layer is increased substantially linearly from 0% to 30%, and has a steep slope at the upper end of the valence band, as compared with the dotted-line band structure. In other words, there is an increased band discontinuity ( Δ Ev) at the interface between the SiGe channel layer **303** and the silicon cap layer **304.**

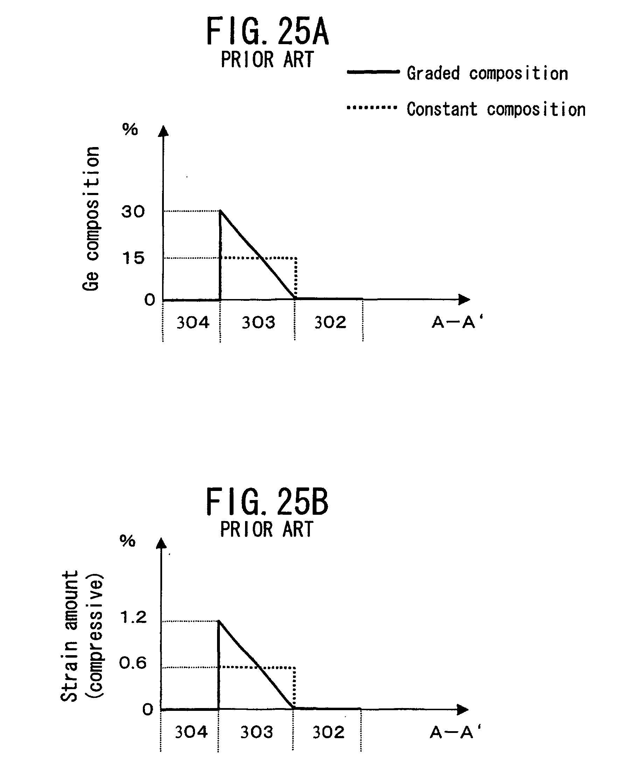

FIG. **25(a)** and FIG. **25(b)** are diagrams illustrating a Ge composition profile and a strain amount profile, respectively. It can be said that since the graded composition shown by a solid line and the constant composition shown by a dotted line have the same strain amount as a whole, they are equivalent to each other in terms of thermal stability.

As illustrated in FIG. **24(a)** and FIG. **24(b),** in a slightly overdriven state, the energy level at the upper end of the valence band takes its maximum value in the SiGe layer **303**, whereby substantially all of the holes are present in the SiGe layer **303,** and a channel that contributes to conduction is formed in the SiGe layer **303**. This channel is formed at a distance equal to the thickness of the silicon cap layer **304** inwardly from the outermost surface of the entire semiconductor layer, and is thus called a "buried channel". However, with strong overdriving, the slope of the profile at the band end of the silicon cap layer **304** becomes steep, whereby holes are present also in the silicon cap layer **304** at the interface with the gate insulating film **305.** The channel formed in the silicon cap layer **304** is called a "parasitic channel".

As described above, holes in the buried channel formed in the SiGe channel layer **303** have a greater mobility than those in Si due to the effect of the strain. On the other hand, holes in the parasitic channel travel with a lower mobility than the mobility in the buried channel because they are subject to scattering due to a roughness of the interface between the gate insulating film **305** and the silicon cap layer **304,** etc. Therefore, when the buried channel is dominant, the hole mobility is large as a whole, and it operates at a higher speed and can achieve a greater current driving power, as compared with a p-MOSFET using Si. However, when the parasitic channel is dominant, the hole mobility as a whole is reduced, thereby inhibiting a high-speed operation and reducing the current driving power.

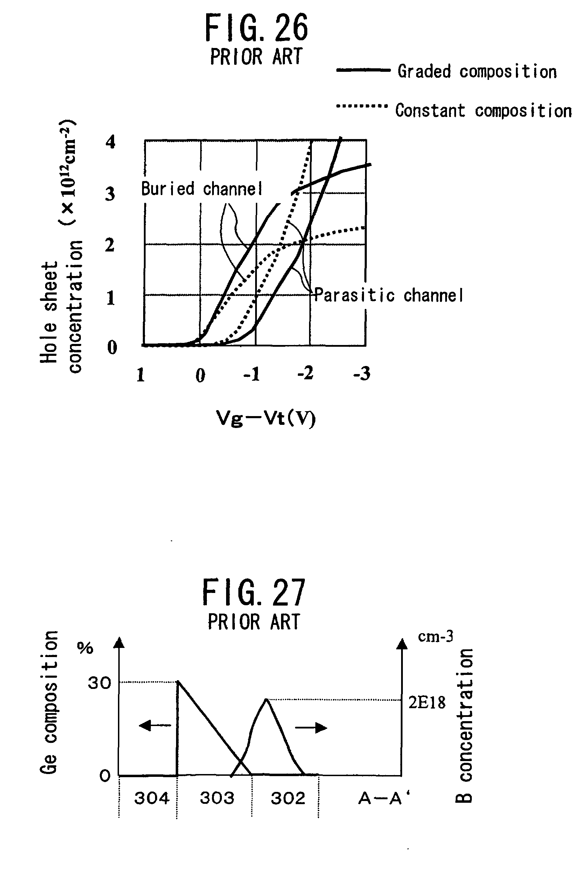

FIG. **26** is a diagram illustrating a gate bias dependence of the sheet carrier concentration (hole sheet concentration) of the buried channel and that of the parasitic channel. Each curve shown by a dotted line in FIG. **26** is for a case where the Ge composition is constant at 15%, and each curve shown by a solid line is for a case where the Ge composition varies linearly from 0% to 30%. As can be inferred from FIG. **24(a)** and FIG. **24(b),** in a case where the Ge composition is varied linearly from 0% to 30% so as to provide an increased band discontinuity ( Δ Ev) at the interface between the SiGe channel layer **303** and the silicon cap layer **304,** as compared to a case where the Ge composition is constant, it is possible to increase the hole sheet concentration in the buried channel and to suppress the hole sheet concentration in the parasitic channel while maintaining a thermal stability of a similar level. As a result, it is possible to maintain a high-speed operation and a high current driving power over a wider range of gate voltage. Conventional examples of such a field effect transistor in which the parasitic channel is suppressed by grading the Ge composition are disclosed in, for example, an article (S. V. Vandebroek et al., IEEE Transactions on Electron Devices, Vol 41, p. 90 (1994)) and United States Patent No. 5,821,577.

Moreover, a modulation doped structure has been employed in the prior art as alternative means for increasing the current driving power of a field effect transistor.

FIG. **27** is a diagram illustrating an example of a Ge composition profile and a p-type impurity concentration (boron in this example) profile in a case where a modulation doped structure is employed. A so-called "δ doped layer", which is doped with a high concentration of an impurity for supplying carriers, is provided in the silicon buffer layer **302** in the vicinity of the channel **303.** The δ doped layer is provided in the silicon cap layer **304** in some cases. In FIG. **27,** the other conditions such as the Ge composition of the channel layer **303,** the size of the transistor, etc., are the same as those of FIG. **22.** By providing the δ doped layer separately from the channel layer so as to spatially separate them from each other, as described above, it is possible to suppress the impurity scattering in the channel and to maintain a high mobility of the carrier traveling through the channel while realizing a high current driving power. A field effect transistor having such a structure in which SiGe is used as a hole channel is described in, for example, S. P. Voinigescu et al., IEDM Tech. Dig., p. 369 (1994).

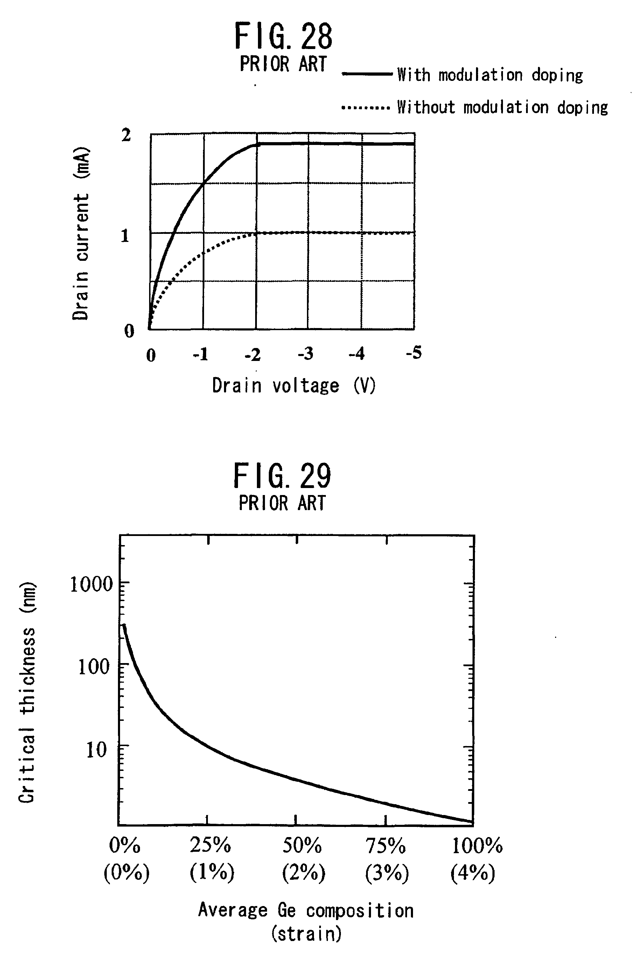

FIG. **28** is a diagram illustrating a drain voltage - drain current characteristics (Vd-Id characteristics) in a transistor whose Ge and boron profiles are as illustrated in FIG. **25(a)** and FIG. **27.** As can be seen from a comparison between the solid line curve and the broken line curve, it is possible to obtain a higher current driving power by employing a modulation doped structure as illustrated in FIG. **27**.

### PROBLEMS TO BE SOLVED

However, such a conventional field effect transistor in which an SiGe layer is used as a channel as described above has the following problems: a problem in thermal stability due to a strain; and a problem of impurity diffusion in modulation doping. These problems will be described below.

In order to suppress a parasitic channel, the band offset value Δ Ev at the interface between the SiGe channel layer and the silicon cap layer can be increased, as described above, which can be achieved by increasing the Ge composition. Then, however, the SiGe channel layer **303** is subject to an increased compressive strain. When the strain is excessive, the crystal can no longer hold its strained state, and is urged to return to its natural lattice constant by causing a crystal defect. This is called a "lattice relaxation". If a crystal lattice relaxation occurs, a localized level occurs due to the crystal defect, which can cause a leak current and a decrease in the hole mobility, thus deteriorating the device characteristics.

The likelihood of the lattice relaxation is also dependent on the thickness of the thin film crystal. That is, there is an upper limit value for the thickness to which a crystal can be grown while accommodating a strain therein (i.e., without causing a lattice relaxation), and the upper limit thickness is called a "critical thickness". FIG. **29** is a diagram illustrating the relationship between the Ge composition of strained SiGe on an Si substrate and the critical thickness. As illustrated in FIG. **29**, the critical thickness decreases rapidly with an increase in the Ge composition, i.e., with an increase in the strain amount. In view of the fact that the SiGe channel layer practically needs to have a thickness of about ten and several nanometers or more, it is necessary to suppress the strain amount to be about 0.5 to 0.8% if possible. This means that it is necessary to suppress the Ge composition to be about 15% or less in order to obtain a transistor having a practical thermal stability, and the Ge composition (15%) of the conventional example substantially corresponds to the upper limit value. On the other hand, also in the conventional example where the Ge composition varies from 0% to 30%, the average Ge composition is 15%, which is equal to the upper limit value in a case where the Ge composition is constant.

It can be seen from the above that the Ge composition can be increased in order to suppress a parasitic channel. Then, however, the strain amount will also increase, whereby the lattice relaxation is more likely to occur. In such a structure, the lattice relaxation is likely to occur also due to a heat treatment during the process of manufacturing the transistor. Thus, the thermal stability is poor. It is necessary to perform a heat treatment at a higher temperature in order to form a gate insulating film with a high quality and to sufficiently activate the impurity in the source region and the drain region, etc. However, as described above, with the thermal stability of the SiGe layer being poor, a sufficient heat treatment cannot be performed and it is not possible to derive a sufficient performance of the transistor.

Moreover, in the modulation doped structure illustrated in FIG. **27,** it is advantageous to bring the δ doped layer as close as possible to the channel layer in order to provide a high current driving power. However, if they are too close to each other, the impurity in the δ doped layer is likely to diffuse from the δ doped layer (peak position) into the channel layer **303,** as illustrated in FIG. **27.** In such a case, there occurs an impurity scattering of the carrier in the channel layer **303,** thereby lowering the carrier mobility and reducing the driving current.

### DISCLOSURE OF THE INVENTION

An object of the present invention is to provide a field effect transistor including an SiGe channel layer in which suppression of a parasitic channel and a desirable thermal stability are both realized, while suppressing diffusion of an impurity into the channel layer.

A p-channel type field effect transistor of the present invention is a field effect transistor formed on a semiconductor substrate, including: a first semiconductor layer made of silicon; a second semiconductor layer provided on the first semiconductor layer and having a composition represented by Si₁₋ₓGeₓ (0<x<1); a third semiconductor layer made of silicon provided on the second semiconductor layer; a gate insulating film provided on the third semiconductor layer; and a gate electrode provided on the gate insulating film, wherein the second semiconductor layer becomes a p-channel region through which holes travel when a negative voltage is applied to the gate electrode, and contains C (carbon) in at least one region thereof.

Thus, C is contained in the second semiconductor layer, whereby the diffusion of an impurity in the second semiconductor layer to be the SiGe channel region is suppressed. Therefore, it is possible to suppress the impurity scattering of the carrier, and to obtain a transistor having a high carrier mobility and a large driving current. Moreover, the strain can be reduced by adjusting the C content. In such a case, the value of the band offset at the upper end of the valence band formed between the first semiconductor layer and the second semiconductor layer does not substantially vary. Therefore, it is possible to reduce the strain to improve the thermal stability while ensuring the same threshold value as that of a transistor having the same Ge composition without C being contained therein. Thus, the carrier mobility is not deteriorated due to the lattice relaxation, whereby it is possible to realize a high current driving power.

Where the second semiconductor layer has a composition in which a Ge content varies, it is possible to realize both the suppression of a parasitic channel and a desirable thermal stability.

Where the second semiconductor layer is configured so that an energy level at an upper end of a valence band thereof takes its maximum value in a region contacting the third semiconductor layer, it is possible to reduce the threshold voltage as much as possible and to ensure a large driving current.

Where the second semiconductor layer contains C in a region including the maximum value of the Ge content, it is possible to reliably prevent an impurity from diffusing into a portion where carriers are actually confined.

Where the second semiconductor layer is configured so that a lattice strain thereof is 0.5% or less in at least one of a region contacting the first semiconductor layer and a region contacting the third semiconductor layer, it is possible to ensure a sufficient thickness of the channel layer in a range such that the lattice relaxation does not occur.

It is more preferred that the second semiconductor layer is configured so as to be lattice-matched with the first semiconductor layer and the third semiconductor layer in all regions.

Where the transistor further includes a δ doped layer containing a high concentration of a p-type impurity provided in a portion of the first semiconductor layer adjacent to the second semiconductor layer, it is possible to suppress the impurity scattering in the channel region while supplied carriers to travel through the channel region.

In such a case, it is preferred that the at least one region of the second semiconductor layer containing C is adjacent to the first semiconductor layer.

Alternatively, the transistor may further include a δ doped layer containing a high concentration of a p-type impurity provided in a portion of the third semiconductor layer adjacent to the second semiconductor layer.

In such a case, it is preferred that the at least one region of the second semiconductor layer containing C is adjacent to the third semiconductor layer.

Where at least one region of the third semiconductor layer contains C, it is possible to suppress the diffusion of an impurity into the gate insulating film, and to prevent the occurrence of problems such as variations in the threshold voltage due to intrusion of the impurity into the gate insulating film.

Where the at least one region of the third semiconductor layer containing C is adjacent to the second semiconductor layer, it is possible to more effectively suppress the diffusion of an impurity in the third semiconductor layer.

It is preferred that the at least one region of the third semiconductor layer containing C is spaced apart from the gate insulating film by 1 nm or more, and more preferably by 2 nm or more. This is for preventing the reliability of the MOS transistor from being lowered through deterioration of the quality of the gate insulating film due to C entering the gate insulating film.

Where a Ge content in the second semiconductor layer exceeds 30%, it is possible to realize a steep impurity concentration profile while increasing the band offset as much as possible.

It is possible to more reliably suppress the occurrence of a parasitic channel where the semiconductor substrate is an SOI substrate obtained by providing a semiconductor layer on an insulative layer; and the first semiconductor layer is a semiconductor layer on the SOI substrate, and is configured so that when a negative voltage is applied to the gate electrode, a depletion layer reaches a lower end surface of the first semiconductor layer.

### BRIEF DESCRIPTION OF THE DRAWINGS

FIG. **1** is a cross-sectional view illustrating a p-type field effect transistor in which a channel layer is made of a C-containing strained SiGe layer.

FIG. **2(a),** FIG. **2(b),** FIG. **2(C)** and FIG. **2(d)** are diagrams illustrating a Ge composition profile in the depth direction, a C composition profile in the depth direction, a profile of the energy level Ev at the upper end of the valence band (with respect to the upper end of Si), and a strain amount profile, respectively, along the cross section of line A-A' of FIG. **1**.

FIG. **3** is a diagram illustrating the relationship among the Ge composition, the C composition, the strain amount and Ev for Si_{1-x-y}GeₓC_{y} (0≦x≦1, 0<Y≦1) that is formed on a silicon substrate while being strained.

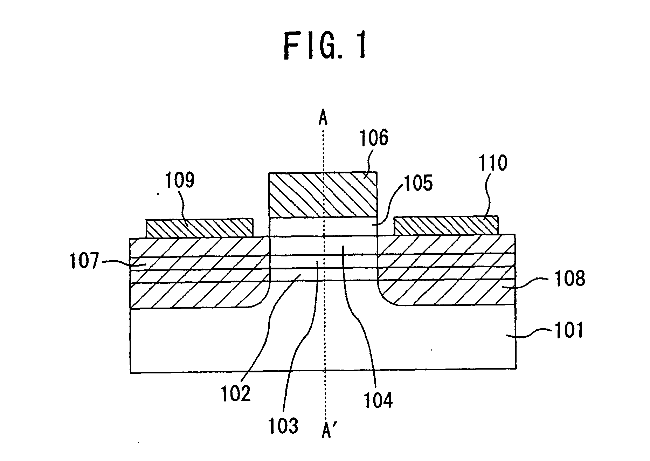

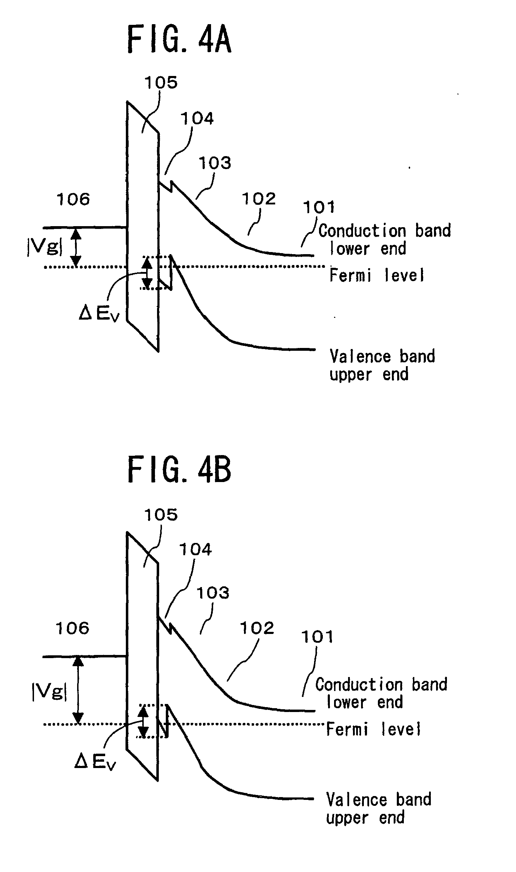

Each of FIG. **4(a)** and FIG. **4(b)** is a diagram illustrating a profile of the conduction band end and the valence band end along the cross section of line A-A' of FIG. **1** when a negative gate voltage Vg is applied to the gate electrode **106** of the p-MOSFET described above.

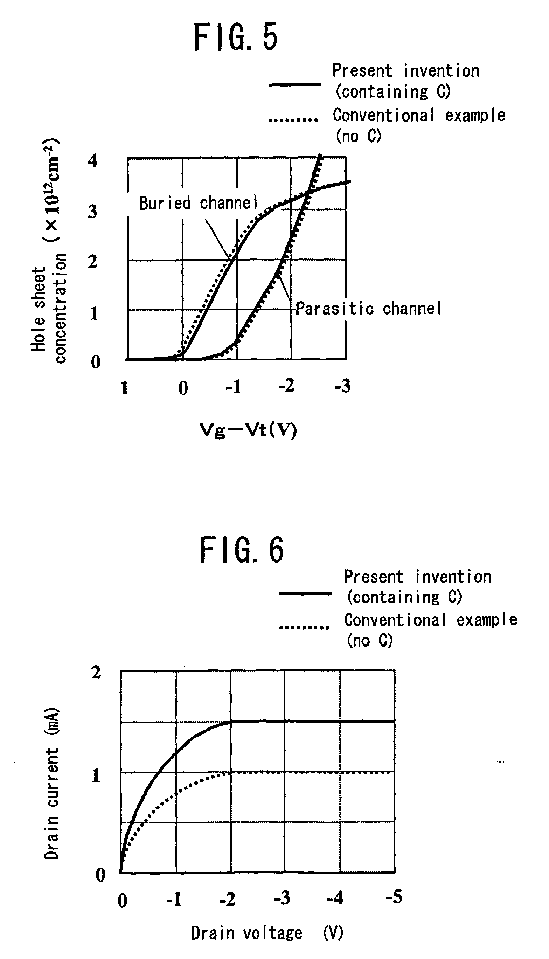

FIG. **5** is a diagram illustrating a gate voltage dependence of the sheet carrier concentration (hole sheet concentration) of the buried channel and that of the parasitic channel.

FIG. **6** is a diagram illustrating the Vd-Id characteristics of the field effect transistor of the present invention containing C in the SiGe channel layer, and that of the conventional field effect transistor containing no C.

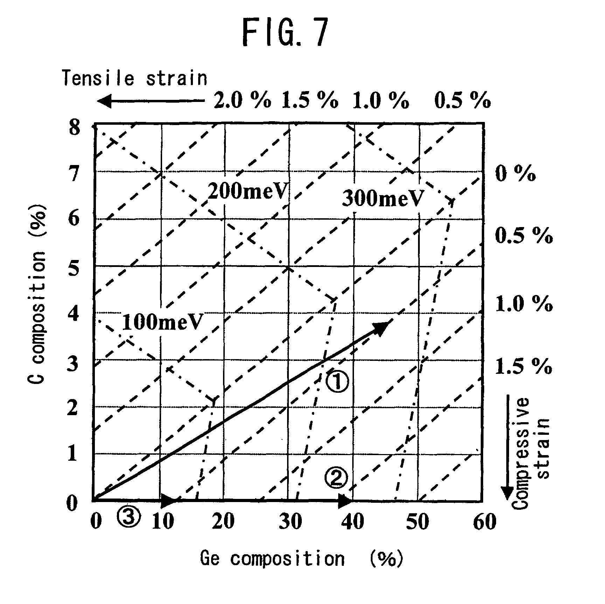

FIG. **7** is a diagram illustrating changes in the Ge composition and the C composition in the channel layer of the SiGeC-pMOSFET of the second embodiment, and that of first and second conventional SiGe-pMOSFETs.

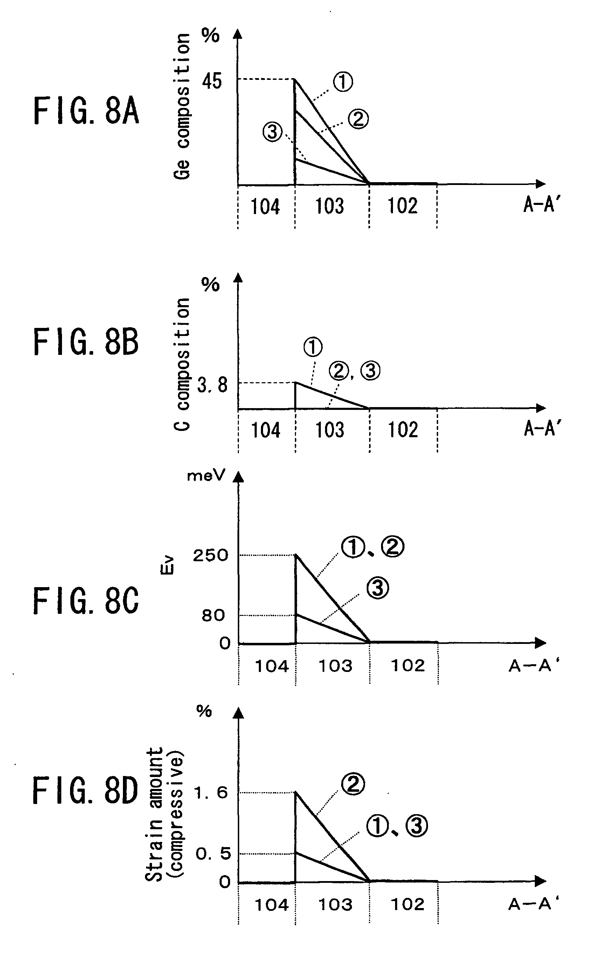

FIG. **8(a),** FIG. **8(b),** FIG. **8(c)** and FIG. **8(d)** are diagrams illustrating a Ge composition profile, a C composition profile, an Ev profile, and a strain amount profile, respectively, for the SiGe-pMOSFET of the present embodiment and the first and second conventional SiGe-pMOSFETs.

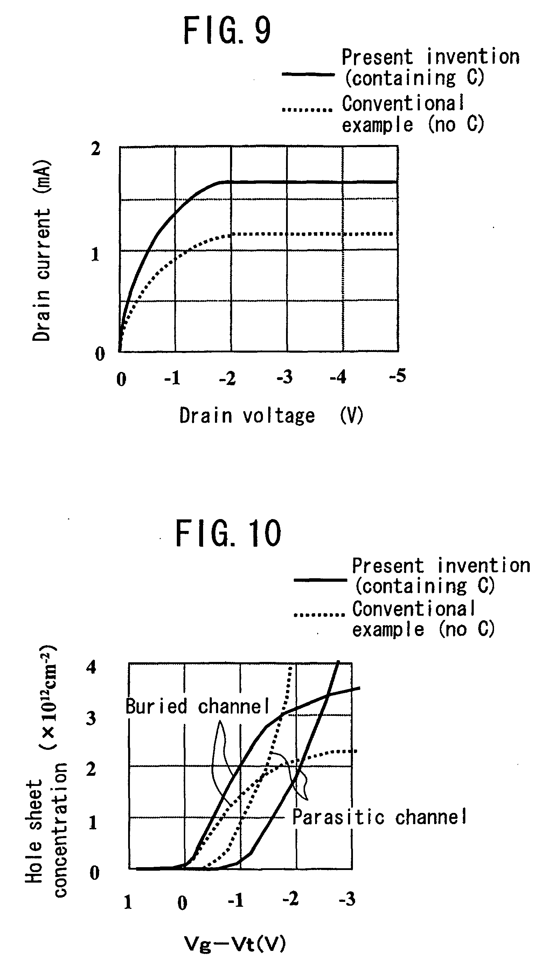

FIG. **9** is a diagram illustrating Vd-Id characteristics of an SiGeC-pMOSFET of the second embodiment of the present invention.

FIG. **10** is a diagram illustrating a gate voltage dependence of the sheet carrier concentration of the buried channel and that of the parasitic channel in the second embodiment.

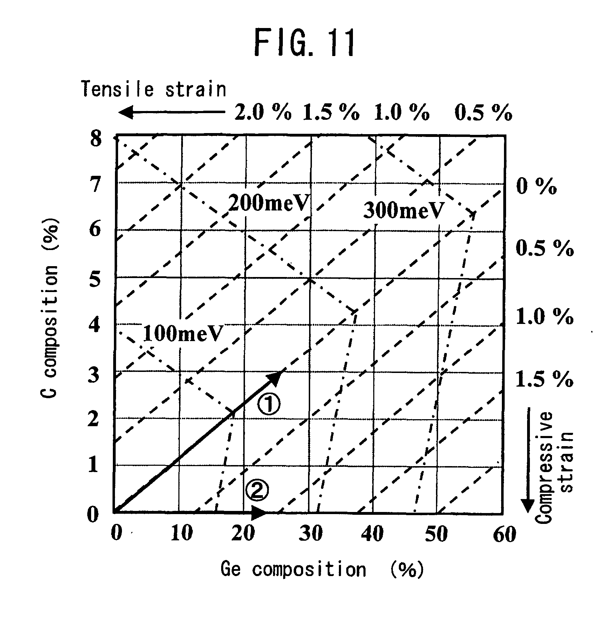

FIG. **11** is a diagram illustrating the Ge and C composition profile in the channel layer of the SiGeC-pMOSFET of the third embodiment, and that of the conventional SiGe-pMOSFET.

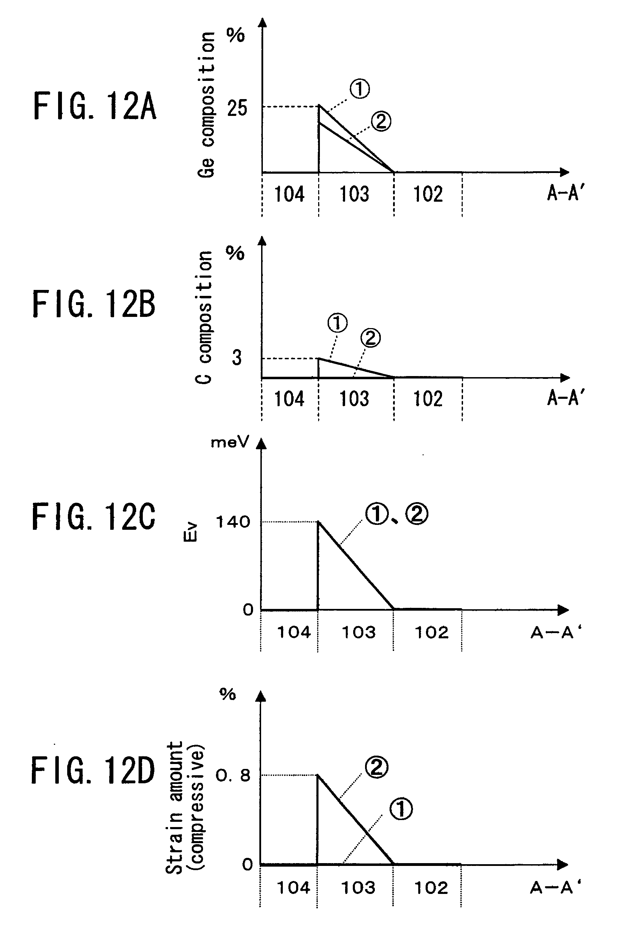

FIG. **12(a),** FIG. **12(b),** FIG. **12(c)** and FIG. **12(d)** are diagrams illustrating a Ge composition profile, a C composition profile, an Ev profile, and a strain amount profile, respectively, for the SiGeC-pMOSFET of the third embodiment and the conventional SiGe-pMOSFET.

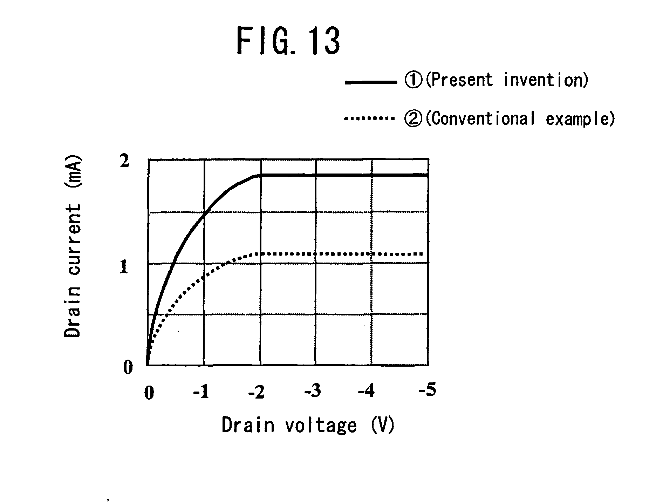

FIG. **13** is a diagram illustrating Vd-Id characteristics of the MOSFET of the third embodiment and that of the conventional MOSFET.

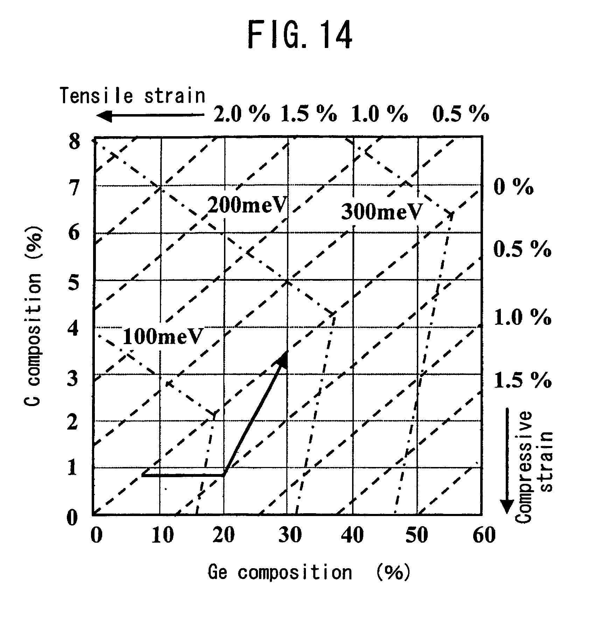

FIG. **14** is a diagram illustrating a profile of the Ge composition and the C composition in the channel layer of the field effect transistor of the fourth and fifth embodiments.

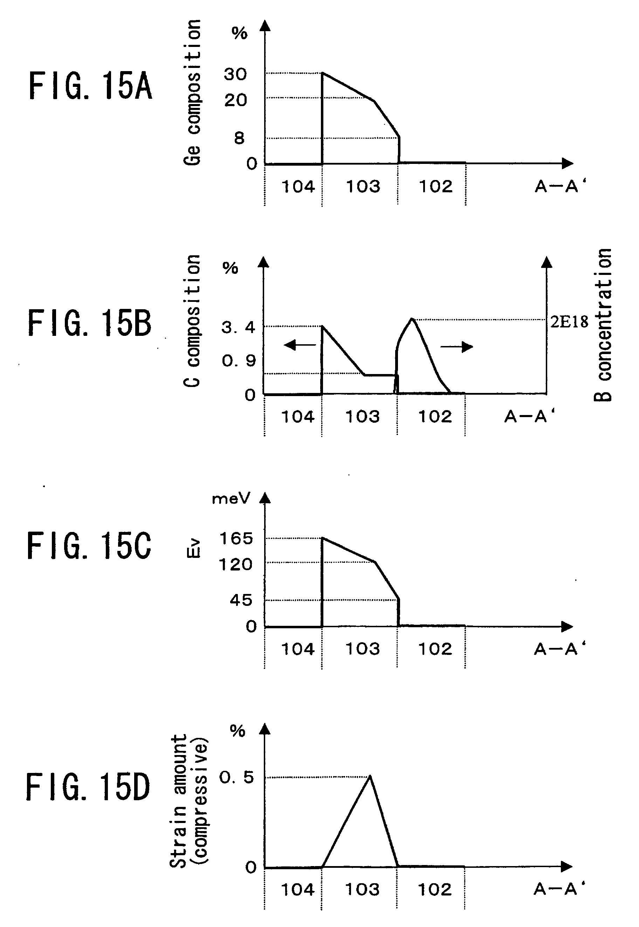

FIG. **15(a),** FIG. **15(b),** FIG. **15(c)** and FIG. **15(d)** are diagrams illustrating a Ge composition profile, a C composition profile and a p-type impurity (boron) concentration profile, an Ev profile, and a strain amount profile, respectively, along the cross section of line A-A' of FIG. **1**, according to the fourth embodiment.

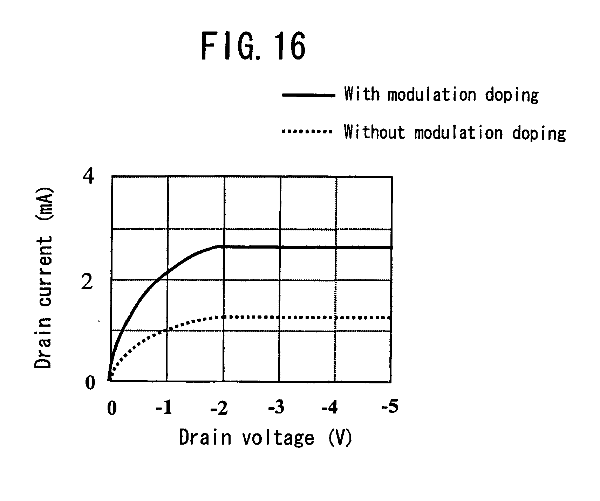

FIG. **16** is a diagram illustrating Vd-Id characteristics of an SiGeC-pMOSFET for a case where there is a p-type impurity doped layer in the silicon buffer layer and for a case where there is no p-type impurity doped layer in the silicon buffer layer.

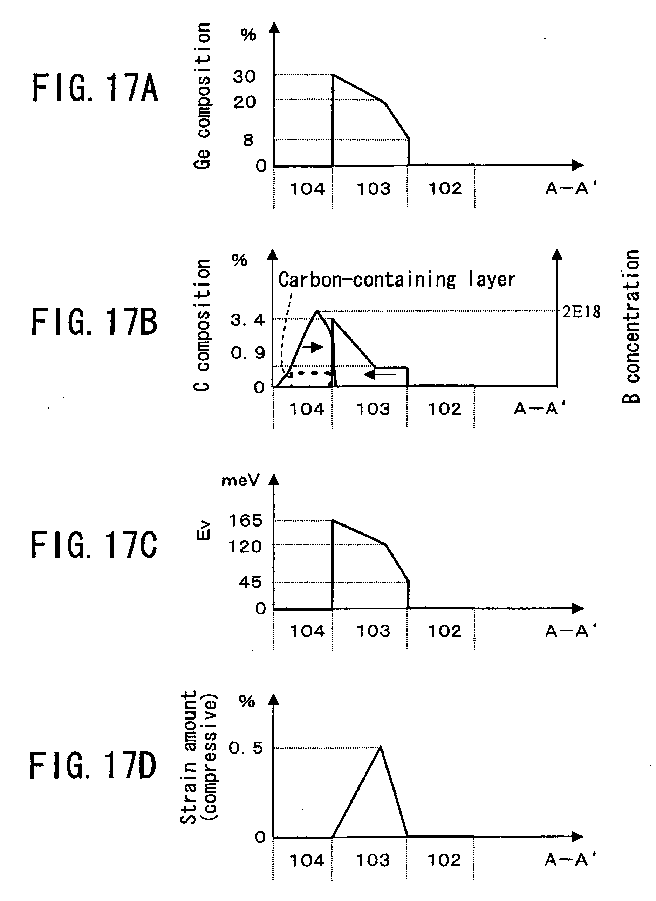

FIG. **17(a),** FIG. **17(b),** FIG. **17(c)** and FIG. **17(d)** are diagrams illustrating a Ge composition profile, a C composition profile and a p-type impurity (boron) concentration profile, an Ev profile, and a strain amount profile, respectively, along the cross section of line A-A' of FIG. **1,** according to the fifth embodiment.

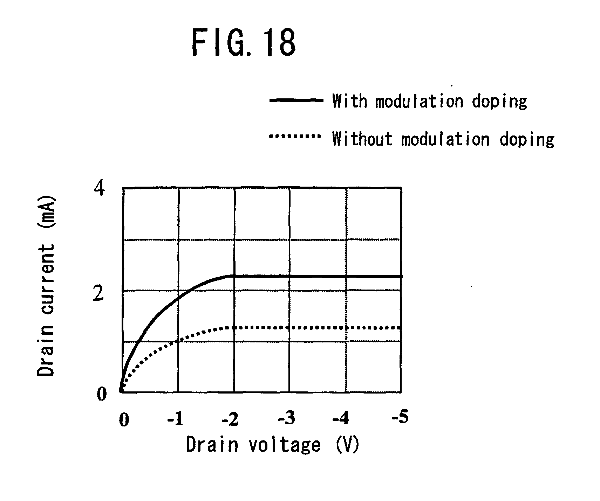

FIG. **18** is a diagram illustrating Vd-Id characteristics of an SiGeC-pMOSFET of the fifth embodiment for a case where there is a p-type impurity doped layer in the silicon cup and for a case where there is no p-type impurity doped layer in the silicon cup layer.

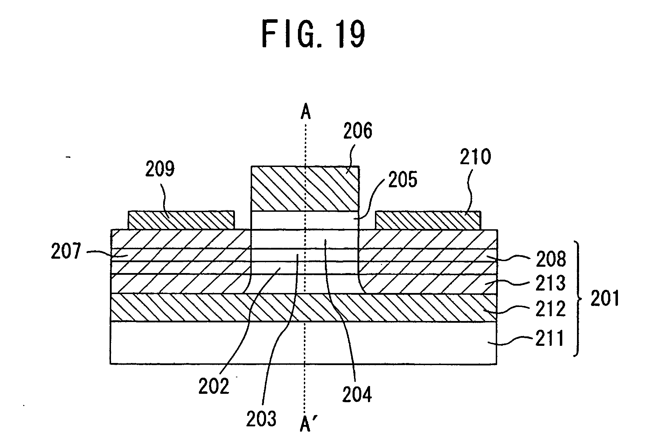

FIG. **19** is a cross-sectional view illustrating an SiGeC-pMOSFET according to the sixth embodiment.

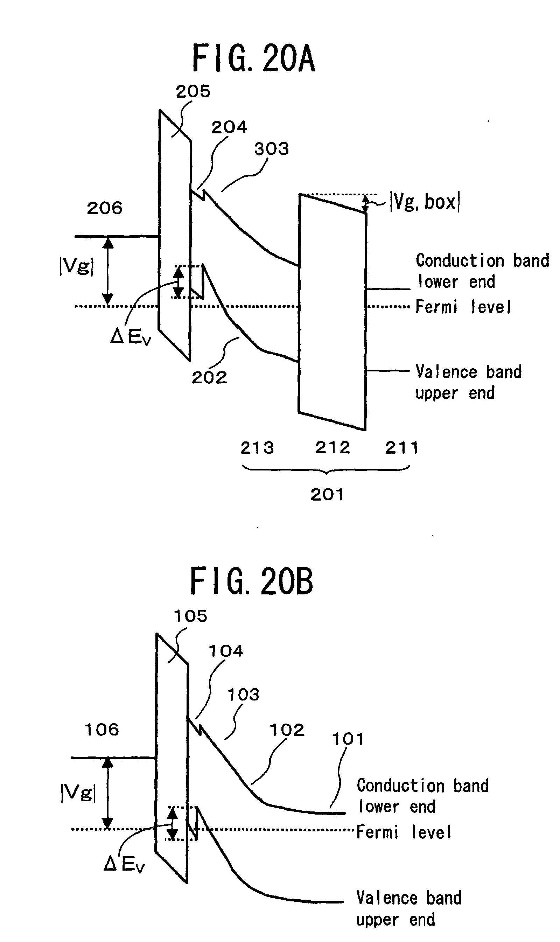

FIG. **20(a)** and FIG. **20(b)** are diagrams illustrating a profile of the conduction band end and the valence band end along the cross section of line A-A' when a negative gate voltage Vg is applied to the gate electrode of the SiGeC-pMOSFET in the sixth and second embodiments, respectively.

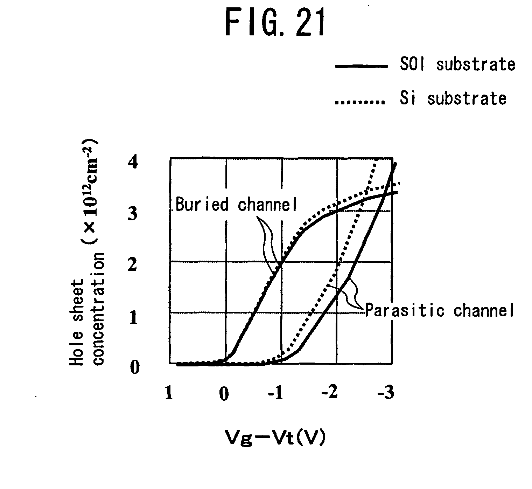

FIG. **21** is a diagram illustrating a gate voltage dependence of the sheet carrier concentration of the buried channel and that of the parasitic channel in the MOSFET of the sixth embodiment.

FIG. **22** is a cross-sectional view illustrating an example of a conventional p-channel type field effect transistor (p-MOSFET).

FIG. **23(a)** and FIG. **23(b)** are respectively a diagram illustrating the difference in lattice constant between an SiGe single crystal and an Si single crystal, and a cross-sectional view illustrating a state where an SiGe layer is epitaxially grown on an Si layer.

FIG. **24(a)** and FIG. **24(b)** are band diagrams illustrating the energy band for a small voltage application and that for a large voltage application, respectively, along a vertical cross section of a conventional p-channel type field effect transistor.

FIG. **25(a)** and FIG. **25(b)** are diagrams illustrating a Ge composition profile and a strain amount profile, respectively, of a conventional p-channel type MOSFET.

FIG. **26** is a diagram illustrating a gate bias dependence of the sheet carrier concentration of holes of the buried channel and that of the parasitic channel in a conventional p-channel type field effect transistor.

FIG. **27** is a diagram illustrating an example of a Ge composition profile and a p-type impurity concentration profile in a case where a modulation doped structure is employed in a conventional p-channel type field effect transistor.

FIG. **28** is a diagram illustrating a drain voltage - drain current characteristics (Vd-Id characteristics) in a conventional p-channel type field effect transistor.

FIG. **29** is a diagram illustrating the relationship between the Ge composition of strained SiGe on an Si substrate and the critical thickness.

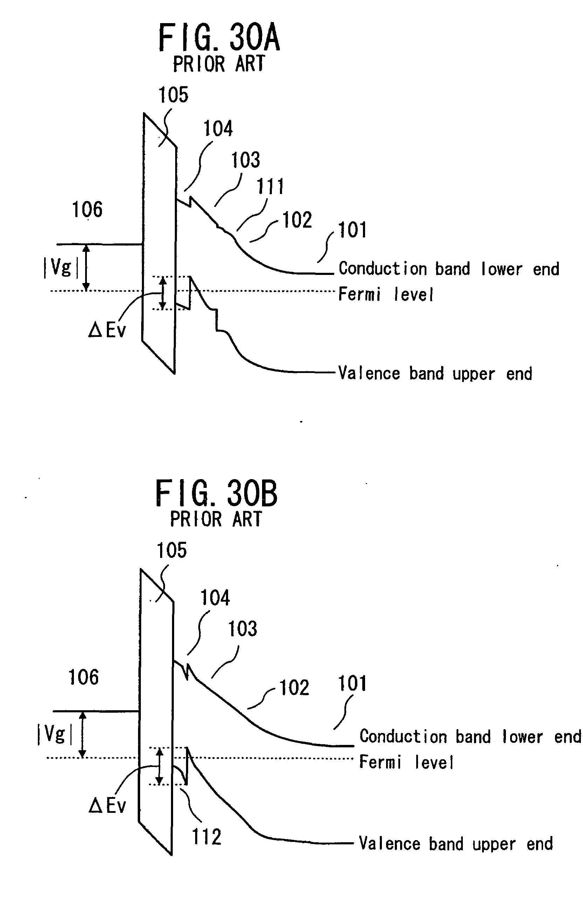

FIG. **30(a)** and FIG. **30(b)** are diagrams illustrating band structures in an SiGeC-pMOSFET with the gate bias being applied for a case where a p-type impurity doped layer is provided in the buffer layer and for a case where it is provided in the cap layer, respectively.

### BEST MODE FOR CARRYING OUT THE INVENTION

### - FIRST EMBODIMENT -

First, the first embodiment of the present invention will be described. FIG. **1** is a cross-sectional view illustrating a p-type field effect transistor in which a channel layer is made of a C-containing strained SiGe layer. A silicon buffer layer **102,** a channel layer **103** and a silicon cap layer **104** are successively epitaxially grown on an n-type silicon substrate **101** by a UHV-CVD method. The channel layer **103** is made of a C-containing strained SiGe layer. The thicknesses of the silicon buffer layer **102,** the channel layer **103** and the silicon cap layer **104** are 10 nm, 10 nm and 5 nm, respectively, and the layers are not subjected to an impurity doping process. Moreover, a gate insulating film **105** made of a silicon oxide film and a gate electrode **106** made of a polysilicon film are provided on the Si cap layer **104.** Moreover, a source region **107** and a drain region **108** containing a high concentration of a p-type impurity (e.g., boron) are formed in portions of the large region across the Si buffer layer **102,** the SiGe channel layer **103** and the Si cap layer **104** that are located on opposing sides of the gate electrode **106.** A source electrode **109** is provided on the source region **107,** and a drain electrode **110** is provided on the drain region **108.** Note that the channel length and the channel width of an MOS type field effect transistor are 0.5 µm and 10 µm, for example.

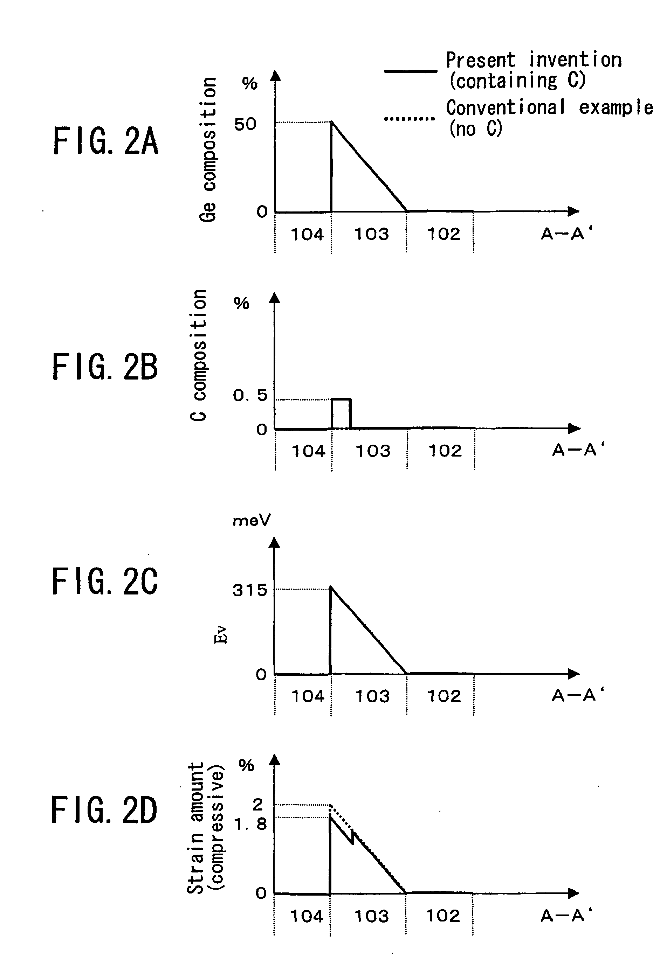

FIG. **2(a),** FIG. **2(b),** FIG. **2(C)** and FIG. **2(d)** are diagrams illustrating a Ge composition profile in the depth direction, a C composition profile in the depth direction, a profile of the energy level Ev at the upper end of the valence band (with respect to the upper end of Si), and a strain amount profile, respectively, along the cross section of line A-A' of FIG. **1.** As illustrated in FIG. **2(a)** and FIG. **2(b),** the Ge composition varies linearly from 0% to 50% from one end closer to the silicon buffer layer **102** toward the other end closer to the silicon cap layer **104**, and C is contained at 0.5% selectively in a region where the Ge composition is 40% to 50%. In FIG. **2(c)** and FIG. **2(d)**, a solid line denotes the field effect transistor of the present embodiment, and a dotted line denotes a conventional field effect transistor in which SiGe having a graded composition with no C is used as a channel. Showing only a solid line indicates that the profile of the present embodiment and that of the conventional example are completely the same or have only a slight difference that is substantially of no significance on this scale.

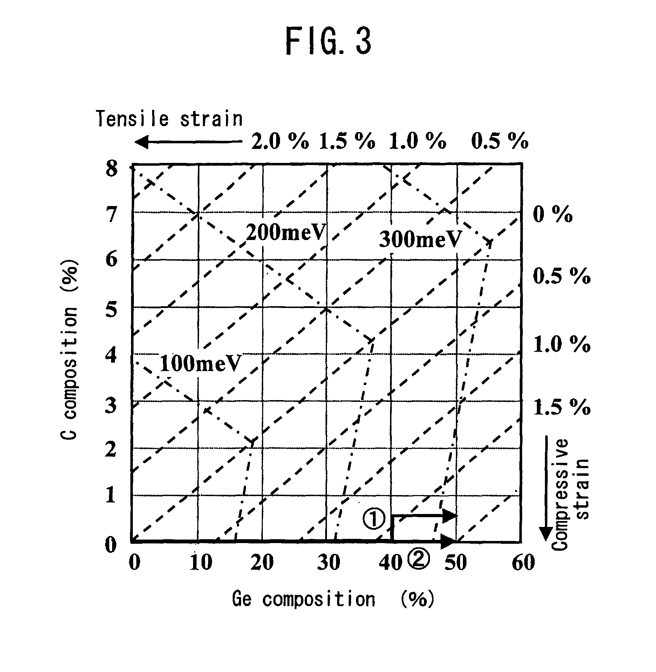

Moreover, FIG. **3** is a diagram illustrating the relationship among the Ge composition, the C composition, the strain amount and Ev for Si_{1-x-y}GeₓC_{y} (0≦x≦1, 0<Y≦1) that is formed on a silicon substrate while being strained. The Ge and C compositions for equal strain amounts and for equal Ev are shown by dotted lines and one-dot chain lines, respectively. In FIG. **3**, changes in the Ge and C composition are shown by arrows. The tail of each arrow represents the composition at one end of the channel layer that is closer to the silicon buffer layer, and the head of each arrow represents the composition at the other end of the channel layer that is closer to the silicon cap layer, indicating that the Ge composition and the C composition are varied along the arrows. Arrow ① denotes the field effect transistor of the present embodiment, and Arrow ② denotes a conventional field effect transistor in which SiGe having a graded composition with no C is used as a channel.

As can be seen from FIG. **2** and FIG. **3**, if C is contained at 0.5% in the region where the Ge composition is 40% to 50% (i.e., a region where it exceeds 30%), the strain amounts can be reduced by about 12% and 10%, respectively, while Ev is not substantially changed. (The difference in Ev is negligible on the scale of FIG. **2(c)**.) Thus, it is possible to increase the driving current while ensuring a large critical thickness of the SiGe channel layer. Particularly, there has been no SiGe-pMOSFET in the prior art in which the Ge content in the SiGe layer exceeds 30%, for practical use, aside from research use, because it is difficult to obtain a thermal stability such that a lattice relaxation does not occur in the process while ensuring a thickness required for obtaining a sufficient driving current within the critical thickness range. In contrast, according to the present embodiment, it is possible to reduce only the lattice strain while ensuring Ev by containing C in a slight amount, whereby it is possible to ensure a sufficient driving current and a great thermal stability even if the Ge content in the SiGe layer (strictly speaking, an SiGeC layer) is 30% or more.

Next, the effect of suppressing a parasitic channel will be described in comparison with the conventional example containing no C. Each of FIG. **4(a)** and FIG. **4(b)** is a diagram illustrating a profile of the conduction band end and the valence band end along the cross section of line A-A' of FIG. **1** when a negative gate voltage Vg is applied to the gate electrode **106** of the p-MOSFET described above. FIG. **4(a)** illustrates a state where the gate voltage is slightly overdriven from the threshold voltage, and FIG. **4(b)** illustrates a state where the gate voltage is strongly overdriven from the threshold voltage. In the figures, regions denoted by reference numerals such as "101" correspond to regions of the reference numerals shown in FIG. **1**. The profile of the upper end of the valence band in the channel layer is substantially the same between the present embodiment and the conventional example containing no C, whereby the general profiles in FIG. **4(a)** and FIG. **4(b)** are also the same. Thus, it is possible to suppress the parasitic channel as in the conventional example having a graded SiGe composition.

FIG. **5** is a diagram illustrating a gate voltage dependence of the sheet carrier concentration (hole sheet concentration) of the buried channel **103** and that of the parasitic channel **104**. As can be seen, the present embodiment and the conventional example having a graded SiGe composition are equivalent to each other with respect to the suppression of the parasitic channel.

FIG. **6** is a diagram illustrating the Vd-Id characteristics of the field effect transistor of the present invention containing C in the SiGe channel layer, and that of the conventional field effect transistor containing no C. As illustrated in FIG. **6,** in the field effect transistor of the present invention, C is contained in a region where the Ge composition is large, thereby obtaining a larger drain current than that of the conventional field effect transistor.

Specifically, according to the present invention, the strain in the channel layer **103** is reduced and the thermal stability is significantly improved by containing C in the channel layer **103,** and it is possible to suppress the lattice relaxation while maintaining a low threshold value because the band offset value from the cap layer is the same as that of a structure having the same Ge composition with no C contained therein. Thus, since the carrier mobility is not deteriorated due to a lattice relaxation in the crystal of the SiGe channel layer, a higher current driving power can be realized than the conventional example having a graded SiGe composition containing no C, thereby providing a practical advantage.

### - SECOND EMBODIMENT -

Next, the second embodiment of the field effect transistor according to the present invention will be described. A field effect transistor in which the channel layer is made of SiGeC (SiGeC-pMOSFET) according to the present invention will be described, in comparison with a conventional field effect transistor in which the channel layer is made of composition-graded SiGe (containing no C) (SiGe-pMOSFET), in order to illustrate the advantage thereof.

The structure of the SiGeC-pMOSFET of the present embodiment is basically the same as that discussed in the first embodiment and illustrated in FIG. **1,** except that the channel layer is entirely made of SiGeC, containing C, and thus will not be further described below. The thicknesses of the silicon buffer layer **102,** the channel layer **103** and the silicon cap layer **104** are 10 nm, 10 nm and 5 nm, respectively, and the layers are not doped with an impurity. The channel length and the channel width of the transistor are 0.5 µm and 10 µm, respectively.

FIG. **7** is a diagram illustrating how to adjust the Ge composition and the C composition in the channel layer of the SiGeC-pMOSFET of the present embodiment, and that of first and second conventional SiGe-pMOSFETs. Arrows ①, ② and ③ in FIG. **7** denote the Ge composition and the C composition in the channel layer of the SiGeC-pMOSFET of the present invention, those of the first conventional SiGe-pMOSFET, and those of the second conventional SiGe-pMOSFET, respectively.

Specifically, in the SiGeC-pMOSFET of the present invention (arrow ①), the channel layer **103** at its end closer to the silicon buffer layer **102** is silicon not containing Ge and C, and the Ge and C compositions at its end closer to the silicon cap layer **104** are 45% and 3.8%, respectively. The Ge composition and the C composition vary linearly from the tail to the head of arrow ①. At the head of arrow ①, the band offset is about 250 meV and the strain amount is about 0.5% (compressive strain).

In the first conventional SiGe-pMOSFET (arrow ②), the channel layer **103** is silicon not containing Ge and C at its end closer to the silicon buffer layer **102,** and the Ge composition at its end closer to the silicon cap layer **104** is 40%. The Ge composition varies linearly from the tail to the head of arrow ②. At the head of arrow ②, Ev is about 250 meV as in the SiGeC-pMOSFET of the present embodiment, and the strain amount is about 1.6% (compressive strain), which is more than three times that of the SiGeC-pMOSFET of the present embodiment.

In the second conventional SiGe-pMOSFET (arrow ③), the channel layer **103** is silicon not containing Ge and C at its end closer to the silicon buffer layer **102,** and the Ge composition at its end closer to the silicon cap layer **104** is 12%. The Ge composition varies linearly from the tail to the head of arrow ③. At the head of arrow ③, Ev is about 80 meV, which is one third of that of the SiGeC-pMOSFET, and the strain amount is about 0.5% (compressive strain) as in the SiGeC-pMOSFET.

FIG. **8(a),** FIG. **8(b),** FIG. **8(c)** and FIG. **8(d)** are diagrams illustrating a Ge composition profile, a C composition profile, an Ev profile, and a strain amount profile, respectively, for the SiGeC-pMOSFET of the present embodiment and the conventional SiGe-pMOSFETs. In the figures, regions denoted by reference numerals correspond to regions of the reference numerals shown in FIG. **1**. Encircled numbers in the figures respectively correspond to the arrow numbers in FIG. **7**.

First, the SiGeC-pMOSFET (arrow ①) of the present embodiment and the first conventional SiGe-pMOSFET (arrow ②) will be compared with each other.

Since the Ev profile in the channel layer **103** is the same between the transistor of the present invention and the first conventional transistor, the general profile from the gate electrode to the Si substrate along the cross section of line A-A' of FIG. **1** is also the same therebetween. Therefore, as described above in the first embodiment, the SiGeC-pMOSFET of the present embodiment and the first conventional SiGe-pMOSFET are equivalent to each other with respect to the suppression of the parasitic channel.

FIG. **9** is a diagram illustrating Vd-Id characteristics of the SiGeC-pMOSFET of the present embodiment. As illustrated in FIG. **8(d),** the SiGeC-pMOSFET of the present embodiment (arrow ①) has a strain amount that is less than one third of that of the first conventional SiGe-pMOSFET (arrow ②), and the thermal stability thereof is significantly improved. Therefore, the crystal lattice relaxation is not likely to occur even through a heat treatment at a high temperature, whereby it is possible to suppress the deterioration of the carrier mobility and to realize a high-speed operation and a high current driving power. Moreover, since a heat treatment at a relatively high temperature can be performed, the gate insulating film **105** can be formed with a high quality, the leak current in the gate insulating film **105** can be reduced, and the resistance can be reduced by sufficiently activating the source region **107** and the drain region **108,** thus realizing a higher transistor performance.

As described above, with the SiGeC-pMOSFET of the present embodiment as compared with the first conventional SiGe-pMOSFET, it is possible to significantly improve the thermal stability while ensuring effects as described above with respect to the suppression of the parasitic channel, whereby it is possible to realize a higher transistor performance, thus providing a practical advantage.

Next, the SiGeC-pMOSFET of the present embodiment (arrow ①) and the second conventional SiGe-pMOSFET (arrow ③) will be compared with each other.

FIG. **10** is a diagram illustrating a gate voltage dependence of the sheet carrier concentration (hole sheet concentration) of the buried channel **103** and that of the parasitic channel **104.** As can be seen from FIG. **8(c),** the Ev value in the channel layer **103** of the present embodiment is more than three times that of the second conventional example. Therefore, with the SiGeC-pMOSFET of the present embodiment, it is possible to increase the hole sheet concentration in the buried channel and to suppress the hole sheet concentration in the parasitic channel. As a result, it is possible to maintain a high-speed operation and a high current driving power over a wider range of gate voltage, thus providing a practical advantage.

Moreover, as illustrated in FIG. **8(d),** the strain amount is the same between the SiGeC-pMOSFET of the present embodiment (arrow ①) and the second conventional SiGe-pMOSFET (arrow ③), and thus it can be considered that the thermal stabilities thereof are substantially equivalent to each other.

As described above, with the SiGeC-pMOSFET of the present embodiment as compared with the second conventional SiGe-pMOSFET, it is possible to significantly suppress the parasitic channel while ensuring similar effects with respect to the thermal stability, whereby it is possible to realize a higher transistor performance, thus providing a practical advantage.

Moreover, the following advantages are also provided by forming the channel layer **103** using SiGeC. As the gate length of a field effect transistor decreases, short channel effects such as a decrease in the threshold voltage become more pronounced. In order to suppress the short channel effects, the implantation profile in the vicinity of the source and drain regions is controlled two-dimensionally in a fine manner by performing, for example, LDD implantation or pocket implantation. However, if a heat treatment at a high temperature for activating an impurity, etc., is performed after the fine profile control, the impurity is diffused so that the two-dimensional profile is blurred, whereby the short channel effects cannot be controlled sufficiently. In contrast, with the field effect transistor of the present embodiment, C is contained in the channel layer, whereby the diffusion of an impurity is suppressed, and the fine two-dimensional profile can be maintained even after a heat treatment at a high temperature, thus suppressing the short channel effects sufficiently.

### - THIRD EMBODIMENT -

The third embodiment of the field effect transistor according to the present invention will be described. A field effect transistor in which the channel layer is made of SiGeC (SiGeC-pMOSFET) of the present embodiment will be described, in comparison with a conventional field effect transistor in which the channel layer is made of composition-graded SiGe (containing no C) (SiGe-pMOSFET), in order to illustrate the advantage thereof.

The structure of the SiGeC-pMOSFET of the present embodiment is basically the same as that of the first embodiment illustrated in FIG. **1,** except that the channel layer is entirely made of SiGeC, containing C, and thus will not be further described below. The thicknesses of the silicon buffer layer **102,** the channel layer **103** and the silicon cap layer **104** are 10 nm, 10 nm and 5 nm, respectively, and the layers are not subjected to an impurity doping process. The channel length and the channel width of the transistor are 0.5 µm and 10 µm, respectively.

FIG. **11** is a diagram illustrating the Ge and C composition profile in the channel layer of the SiGeC-pMOSFET of the present embodiment, and that of the conventional SiGe-pMOSFET. Arrows ① and ② in FIG. **11** denote the Ge and C composition profile in the channel layer of the pMOSFET of the present embodiment and that of the conventional pMOSFET, respectively.

Specifically, in the SiGeC-pMOSFET of the present embodiment (arrow ①), the channel layer **103** at its end closer to the silicon buffer layer **102** is silicon not containing Ge and C, and the Ge and C compositions at its end closer to the silicon cap layer **104** are 25% and 3%, respectively. The Ge composition and the C composition vary linearly from the tail to the head of arrow ①. At the head of arrow ①, Ev is about 140 meV. Moreover, the strain amount of the channel layer **103** is 0% anywhere from a portion thereof contacting the silicon buffer layer **102** to a portion thereof contacting the silicon cap layer **104,** and the channel layer **103** is lattice-matched with the silicon substrate **101.** Even in a case where the channel layer **103** has no strain, a hole in the SiGeC layer has a greater mobility than that of a hole in the Si layer due to the nature of material of SiGeC, whereby it is possible to realize a high-speed operation of a field effect transistor.

In the conventional SiGe-pMOSFET (arrow ②), the channel layer **103** is silicon not containing Ge and C at its end closer to the silicon buffer layer **102,** and the Ge composition at its end closer to the silicon cap layer **104** is 22%. The Ge composition varies linearly from the tail to the head of arrow ②. At the head of arrow ②, Ev is about 140 meV and the strain amount is about 0.8% (compressive strain).

FIG. **12(a),** FIG. **12(b),** FIG. **12(c)** and FIG. **12(d)** are diagrams illustrating a Ge composition profile, a C composition profile, an Ev profile, and a strain amount profile, respectively, for the SiGeC-pMOSFET of the third embodiment and the conventional SiGe-pMOSFET. The numbers in the figures respectively correspond to the arrow numbers in FIG. **11**.

Since the Ev profile in the channel layer **103** is the same between the transistor of the present invention and the conventional transistor, the general profile from the gate electrode to the Si substrate along the cross section of line A-A' of FIG. **1** is also the same therebetween. Therefore, as described above in the first embodiment, the SiGeC-pMOSFET of the present embodiment (arrow ①) and the conventional SiGe-pMOSFET (arrow ②) are equivalent to each other with respect to the suppression of the parasitic channel.

FIG. **13** is a diagram illustrating Vd-Id characteristics of the MOSFET of the present embodiment and that of the conventional MOSFET. As illustrated in FIG. **12(d),** in the SiGeC-pMOSFET of the present embodiment, the channel layer **103** is lattice-matched with the silicon substrate **101,** and thus the strain amount thereof is 0% anywhere. Therefore, the thermal stability improves dramatically to a level equivalent to that of Si. Therefore, it can be seen that since the crystal lattice relaxation does not occur even through a heat treatment at a high temperature, and thus the carrier mobility does not deteriorate, it is possible to realize a high-speed operation and a high current driving power. Moreover, since a heat treatment at a relatively high temperature can be performed, the gate insulating film **105** can be formed with a high quality, the leak current in the gate insulating film can be reduced, and the resistance can be reduced by sufficiently activating the source region **107** and the drain region **108,** thus realizing a higher transistor performance.

As described above, with the SiGeC-pMOSFET of the present embodiment as compared with the conventional SiGe-pMOSFET, it is possible to dramatically improve the thermal stability while ensuring effects as described above with respect to the suppression of the parasitic channel, whereby it is possible to realize a higher transistor performance, thus providing a practical advantage.

### - FOURTH EMBODIMENT -

Next, the fourth embodiment of the present invention will be described. Also in the present embodiment, the structure of the field effect transistor is basically the same as the structure of the first embodiment illustrated in FIG. **1.** However, the present embodiment is characterized in that the channel layer has a modulation doped structure, and a high concentration p-type impurity doped layer (δ doped layer) is included in the silicon buffer layer **102.** The thicknesses of the silicon buffer layer **102,** the channel layer **103** and the silicon cap layer **104** are 10 nm, 10 nm and 5 nm, respectively, and the channel layer and the silicon cap layet are not doped with an impurity. The channel length and the channel width of the transistor are 0.5 µm and 10 µm, respectively.

FIG. **14** is a diagram illustrating a profile of the Ge composition and the C composition in the channel layer of the field effect transistor of the present embodiment. An arrow in FIG. **14** denotes changes in the Ge composition and the C composition in the channel layer of the field effect transistor of the present embodiment.

Specifically, in the channel layer **103** of the field effect transistor of the present embodiment, the Ge composition and the C composition at its end closer to the silicon buffer layer **102** are 8% and 0.9%, respectively. Moreover, as indicated by the arrow, the Ge composition in the channel layer increases linearly toward the silicon cap layer **104,** and the Ge composition and the C composition are 20% and 0.9%, respectively, at a depth in the channel layer. Furthermore, in the channel layer, the Ge composition and the C composition again increase linearly toward the silicon cap layer **104,** and the Ge composition and the C composition are 30% and 3.4%, respectively, at its end closer to the silicon cap layer **104.**

FIG. **15(a),** FIG. **15(b),** FIG. **15(c)** and FIG. **15(d)** are diagrams illustrating a Ge composition profile, a C composition profile and a p-type impurity (boron) concentration profile, an Ev profile, and a strain amount profile, respectively, along the cross section of line A-A' of FIG. **1.** The illustrated profiles are those obtained after the transistor is manufactured. It can be seen that although boron is diffused through a heat treatment in the manufacturing process, the diffusion of boron into the channel layer is inhibited by C in the channel layer **103**.

Thus, with the field effect transistor of the present embodiment, it is possible to realize a high-speed operation by preventing deterioration of the mobility due to an impurity scattering in the channel layer. Moreover, this means that the high concentration p-type impurity doped layer can be brought as close as possible to the channel layer **103**. Therefore, a higher current driving power can be obtained in the present embodiment.

Next, as illustrated in FIG. **15(c),** Ev in the channel layer **103** increases monotonically from its end closer to the silicon buffer layer **102** to its end closer to the silicon cap layer **104,** and is about 45 meV at the end closer to the silicon buffer layer **102** and about 165 meV at the end closer to the silicon cap layer **104.** Therefore, a sufficient band offset is obtained at the end of the channel layer **103** closer to the silicon cap layer **104,** whereby it is possible to reliably suppress the formation of the parasitic channel while maintaining a small threshold voltage.

Next, as illustrated in FIG. **15(d),** the strain amount in the channel layer **103** takes its maximum value of 0.5% at a position in the middle of the channel layer **103** where the Ge composition is 20% and the C composition is 0.9%, and the strain amount is 0% (no strain) both at its end closer to the silicon buffer layer **102** and at its end closer to the silicon cap layer **104.** In the field effect transistor of the present embodiment, the channel layer **103** is lattice-matched with the silicon layer both at its end closer to the silicon buffer layer **102** and its end closer to the silicon cap layer **104,** whereby the field effect transistor has a desirable thermal stability. Therefore, the crystal lattice relaxation is not likely to occur even through a heat treatment at a high temperature, and the deterioration of the carrier mobility is prevented, whereby it is possible to realize a field effect transistor with a high-speed operation and a high current driving power. Moreover, since a heat treatment at a high temperature can be performed, the gate insulating film **105** can be formed with a high quality, the leak current in the gate insulating film can be reduced, and the resistance can be reduced by sufficiently activating the source region **107** and the drain region **108,** thus realizing a higher transistor performance.

FIG. **16** is a diagram illustrating Vd-Id characteristics of an SiGeC-pMOSFET for a case where there is a p-type impurity doped layer (δ doped layer) in the silicon buffer layer and for a case where there is no p-type impurity doped layer (δ doped layer) in the silicon buffer layer. As illustrated in the figure, the current driving power can be further increased by employing a modulation doped structure by providing the δ doped layer.

FIG. **30(a)** and FIG. **30(b)** are diagrams illustrating band structures in an SiGeC-pMOSFET with the gate bias being applied for a case where a p-type impurity doped layer (δ doped layer) is provided in the silicon buffer layer and for a case where it is provided in the silicon cap layer, respectively. As illustrated in the figures, particularly when the δ doped layer is provided in the silicon cap layer, a sharp trough is formed in the band offset portion, whereby it is possible to further enhance the carrier confining function.

As described above, with the field effect transistor of the present embodiment, it is possible not only to improve the thermal stability while reliably suppressing the formation of the parasitic channel, but also to increase the current driving power by employing the modulation doped structure, whereby it is possible to realize a higher transistor performance, thus providing a practical advantage.

### - FIFTH EMBODIMENT -

Next, the fifth embodiment of the present invention will be described. Also in the present embodiment, the structure of the field effect transistor is basically the same as the structure of the first embodiment illustrated in FIG. **1**. However, the present embodiment is characterized in that the transistor has a modulation doped structure, and a high concentration p-type impurity doped layer ( δ doped layer) is included in the silicon cap layer **104.** The thicknesses of the silicon buffer layer **102,** the channel layer **103** and the silicon cap layer **104** are 10 nm, 10 nm and 5 nm, respectively, and the channel layer and the silicon buffer layer are not doped with an impurity. The channel length and the channel width of the transistor are 0.5 µm and 10 µm, respectively.

Also in the present embodiment, the Ge composition and C composition profile in the channel layer of the field effect transistor is as that of the fourth embodiment shown by the arrow in FIG. **14.**

FIG. **17(a),** FIG. **17(b),** FIG. **17(c)** and FIG. **17(d)** are diagrams illustrating a Ge composition profile, a C composition profile and a p-type impurity (boron) concentration profile, an Ev profile, and a strain amount profile, respectively, along the cross section of line A-A' of FIG. **1.** The illustrated profiles are those obtained after the transistor is manufactured. As illustrated in FIG. **17(b),** it can be seen that although boron is diffused through a heat treatment in the manufacturing process, the diffusion of boron in the channel layer is inhibited by C in the channel layer **103.**

Thus, with the field effect transistor of the present embodiment, it is possible to realize a high-speed operation by preventing deterioration of the mobility due to an impurity scattering in the channel layer. Moreover, this means that the high concentration p-type impurity doped layer (δ doped layer) can be brought as close as possible to the channel layer **103.** Therefore, a higher current driving power can be obtained.

Next, as illustrated in FIG. **17(c)** and FIG. **17(d),** also in the present embodiment, as in the fourth embodiment, the Ev value is sufficiently large at one end of the channel layer **103** closer to the silicon cap layer **104,** whereby it is possible to ensure a large band offset and to sufficiently suppress the parasitic channel. Moreover, the strain amount in the channel layer **103** is 0% both at its end closer to the silicon buffer layer **102** and at its end closer to the silicon cap layer **104,** whereby the MOSFET of the present embodiment also has a desirable thermal stability, as in the fourth embodiment.

FIG. **18** is a diagram illustrating Vd-Id characteristics of an SiGeC-pMOSFET for a case where there is a p-type impurity doped layer (δ doped layer) in the silicon cup layer and for a case where there is no p-type impurity doped layer (δ doped layer) in the silicon cup layer. As illustrated in the figure, the current driving power can be further increased by employing a modulation doped structure by providing the p-type impurity doped layer (δ doped layer).

If a region in the silicon cap layer **104** including at least a portion of the p-type impurity doped layer (δ doped layer) that is doped with a high concentration of a p-type impurity (e.g., boron) is made of a carbon-containing layer that contains carbon (e.g., 0.3%), as indicated by a broken line of FIG. **17(b),** it is possible to suppress the diffusion of the p-type impurity (e.g., boron) into the channel region and the gate oxide film. In this way, it is possible to suppress the occurrence of variations in the threshold voltage of the transistor due to intrusion of boron, etc., into the gate oxide film. The extent of the carbon-containing layer is preferably spaced apart from the gate oxide film by 1 nm or more, and more preferably by 2 nm or more. This is for preventing the reliability of the MOS transistor from being lowered through deterioration of the quality of the gate insulating film due to C entering the gate oxide film.

As described above, with the field effect transistor of the present embodiment, it is possible not only to improve the thermal stability while reliably suppressing the formation of the parasitic channel, but also to increase the current driving power by employing the modulation doped structure, whereby it is possible to realize a higher transistor performance, thus providing a practical advantage.

### - SIXTH EMBODIMENT -

Next, in the present embodiment, a p-type field effect transistor (SiGeC-pMOSFET) that is formed on an SOI substrate and in which a channel layer is made of a strained SiGeC layer will be described.

FIG. **19** is a cross-sectional view illustrating an SiGeC-pMOSFET according to the present embodiment. A silicon buffer layer **202,** a channel layer **203** and a silicon cap layer **204** are successively epitaxially grown on a surface silicon layer **213** of an SOI substrate **201** by a UHV-CVD method, the SOI substrate **201** including a silicon substrate **211,** a buried oxide film **212** and the surface silicon layer **213.** The channel layer **203** is made of SiGeC. The thickness of the surface silicon layer **213** on the buried oxide film **212** is 30 nm, and the transistor is configured so as to operate as a so-called "complete depletion type" field effect transistor with the entire active region becoming a depletion layer upon application of a voltage thereto.

The thicknesses of the silicon buffer layer **202,** the channel layer **203** and the silicon cap layer **204** are 10 nm, 10 nm and 5 nm, respectively, and the layers are not subjected to an impurity doping process. A gate insulating film **205** made of a silicon oxide film and a gate electrode **206** made of a polysilicon film are provided on the Si cap layer **204.** Moreover, a source region **207** and a drain region **208** containing a high concentration of a p-type impurity (e.g., boron) are formed in portions of the large region across the Si buffer layer **202,** the SiGe channel layer **203** and the Si cap layer **204** that are located on opposing sides of the gate electrode **206.** A source electrode **209** is provided on the source region **207,** and a drain electrode **210** is provided on the drain region **208.** Note that the channel length and the channel width of an MOS type field effect transistor are 0.5 µm and 10 µm, for example.

The Ge and C composition profile in the channel layer of the field effect transistor of the present embodiment is the same as that of the second embodiment shown by arrow ① in FIG. **7.** Specifically, in the SiGeC-pMOSFET of the present embodiment, the channel layer **203** at its end closer to the silicon buffer layer **202** is silicon not containing Ge and C, and the Ge and C compositions at its end closer to the silicon cap layer **204** are 45% and 3.8%, respectively. The Ge composition and the C composition vary linearly from the tail to the head of arrow ① in FIG. **7.** At the head of arrow ①, the band offset is about 250 meV and the strain amount is about 0.5% (compressive strain).

FIG. **20(a)** and FIG. **20(b)** are diagrams illustrating a profile of the conduction band end and the valence band end along the cross section of line A-A' when a negative gate voltage Vg is applied to the gate electrode **206** of the SiGeC-pMOSFET in the present embodiment and in the second embodiment, respectively.

As illustrated in FIG. **20(a),** in the SiGeC-pMOSFET of the present embodiment, the surface silicon layer **213** is completely depleted, whereby a portion of the gate voltage Vg (Vg, box) is applied also to the buried oxide film **212.** Therefore, the voltage applied to the silicon cap layer **204** is smaller than that in the SiGeC-pMOSFET (FIG. **20(b))** as described above in the second embodiment, with the same gate voltage Vg being applied to the gate electrode **206**. Therefore, in the SiGeC-pMOSFET on the complete depletion type SOI substrate, the curve of the band in the vicinity of the silicon cap layer **204** is gentle. As is apparent from FIG. **20(a),** the formation of the parasitic channel can be suppressed more strongly than in the second embodiment.

FIG. **21** is a diagram illustrating a gate voltage dependence of the sheet carrier concentration of the buried channel **203** and that of the parasitic channel **204** in the MOSFET of the present embodiment.

As described above, in the SiGeC-pMOSFET on the SOI substrate according to the present embodiment, the surface silicon layer of the SOI substrate is completely depleted, whereby the formation of the parasitic channel can be suppressed more strongly as compared with an SiGeC-pMOSFET on a normal silicon substrate having the same graded composition (not an SOI substrate), thus providing a practical advantage.

Note that while an oxide film is employed for the gate insulating film in all of the embodiments described above, effects as those described above can be obtained by the present invention even if it is a different insulative film such as a nitride film.

According to the present invention, the channel layer is made of C-containing SiGe (or SiGeC), whereby it is possible to more strongly confine holes in the buried channel and to more strongly suppress the parasitic channel, while suppressing the strain amount across the entire channel layer and maintaining a sufficient thermal stability, thus providing a practical advantage. Moreover, the addition of C provides an effect that it is possible to realize a higher current driving power by suppressing the diffusion of an impurity into the channel layer in a modulation doped structure. Furthermore, it is possible to further increase the effect of suppressing the parasitic channel by forming the transistor of an embodiment of the present invention on an SOI substrate.

### INDUSTRIAL APPLICABILITY

A semiconductor device of the present invention can be used in devices such as an Si/SiGe hetero junction type or Si/SiGeC hetero junction type MOSFET, DTMOS, etc., that are mounted on electronic equipment.

## Claims

1. A p-channel type field effect transistor, being a field effect transistor formed on a semiconductor substrate, comprising:
a first semiconductor layer made of silicon;
a second semiconductor layer provided on the first semiconductor layer and having a composition represented by Si₁₋ₓGeₓ (0<x<1);
a third semiconductor layer made of silicon provided on the second semiconductor layer;
a gate insulating film provided on the third semiconductor layer; and
a gate electrode provided on the gate insulating film,
wherein the second semiconductor layer becomes a p-channel region through which holes travel when a negative voltage is applied to the gate electrode, and contains C (carbon) in at least one region thereof.

2. The p-channel type field effect transistor of claim 1, wherein the second semiconductor layer has a composition in which a Ge content varies.

3. The p-channel type field effect transistor of claim 2, wherein the second semiconductor layer is configured so that an energy level at an upper end of a valence band thereof takes its maximum value in a region contacting the third semiconductor layer.

4. The p-channel type field effect transistor of claim 2 or 3, wherein the second semiconductor layer contains C in a region including the maximum value of the Ge content.

5. The p-channel type field effect transistor of any of claims 1 to 4, wherein the second semiconductor layer is configured so that a lattice strain thereof is 0.5% or less in at least one of a region contacting the first semiconductor layer and a region contacting the third semiconductor layer.

6. The p-channel type field effect transistor of any of claims 1 to 4, wherein the second semiconductor layer is configured so as to be lattice-matched with the first semiconductor layer and the third semiconductor layer in all regions.

7. The p-channel type field effect transistor of any of claims 1 to 6, further comprising a δ doped layer containing a high concentration of a p-type impurity provided in a portion of the first semiconductor layer adjacent to the second semiconductor layer.

8. The p-channel type field effect transistor of claim 7, wherein the at least one region of the second semiconductor layer containing C is adjacent to the first semiconductor layer.

9. The p-channel type field effect transistor of any of claims 1 to 8, further comprising a δ doped layer containing a high concentration of a p-type impurity provided in a portion of the third semiconductor layer adjacent to the second semiconductor layer.

10. The p-channel type field effect transistor of claim 9, wherein the at least one region of the second semiconductor layer containing C is adjacent to the third semiconductor layer.

11. The p-channel type field effect transistor of any of claims 1 to 10, wherein at least one region of the third semiconductor layer contains C.

12. The p-channel type field effect transistor of claim 11, wherein the at least one region of the third semiconductor layer containing C is adjacent to the second semiconductor layer.

13. The p-channel type field effect transistor of claim 11, wherein the at least one region of the third semiconductor layer containing C is spaced apart from the gate insulating film by 1 nm or more.

14. The p-channel type field effect transistor of claim 11, wherein the at least one region of the third semiconductor layer containing C is spaced apart from the gate insulating film by 2 nm or more.

15. The p-channel type field effect transistor of any of claims 1 to 14, wherein a Ge content in the second semiconductor layer exceeds 30%.

16. The p-channel type field effect transistor of any of claims 1 to 15, wherein:
the semiconductor substrate is an SOI substrate obtained by providing a semiconductor layer on an insulative layer; and
the first semiconductor layer is a semiconductor layer on the SOI substrate, and is configured so that when a negative voltage is applied to the gate electrode, a depletion layer reaches a lower end surface of the first semiconductor layer.
